# EUROPEAN PATENT SPECIFICATION

(11) **EP 0 454 055 B1**
(45) Date of publication and mention of the grant of the patent: **27.11.1996**
(21) Application number: 91106512.6
(22) Date of filing: 23.04.1991
(51) Int. Cl.: H01L 21/3215, H01L 21/225, H01L 21/3205, H01L 21/223, H01L 21/265

(54) **Semiconductor device and method for manufacturing the same**
Halbleiteranordnung und Verfahren zur Herstellung
Dispositif semi-conducteur et son procédé de fabrication

(30) Priority: 23.04.1990 JP 105299/90
(43) Date of publication of application: 30.10.1991
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi (JP)
(72) Inventor: Mikata, Yuuichi, c/o Intellectual Property Div., Minato-ku, Tokyo 105 (JP); Ishihara, Katsunori, c/o Intellectual Property Div, Minato-ku, Tokyo 105 (JP); Okumura, Katsuya, c/o Intellectual Property Div., Minato-ku, Tokyo 105 (JP)
(74) Representative: Lehn, Werner, Dipl.-Ing.

(56) References cited:
- EP-A- 0 410 390
- EP-A- 0 430 166
- US-A- 4 143 178
- US-A- 4 764 478
- SYMPOSIUM ON VLSI TECHNOLOGY-DIGEST OF TECHNICAL PAPERS 22 May 1989, KYOTO pages 41 - 42 K.SAWADA ET AL. 'Formation of polysilicon electrodes in deep trenches with two-step continuous deposition of in-situ doped and undoped polysilicon films'
- JOURNAL OF APPLIED PHYSICS. vol. 65, no. 11, 1 June 1989, NEW YORK US pages 4435 - 4437 S.F. GONG ET AL. 'A metal-oxide-silicon field-effect transistor made by means of solid-phase doping'
- JOURNAL OF APPLIED PHYSICS. vol. 62, no. 9, 1 November 1987, NEW YORK US pages 3726 - 3732 S.F GONG ET AL. 'Al-doped and Sb-doped polycrystalline silicon obtained by means of metal-induced crystallization'
- PATENT ABSTRACTS OF JAPAN vol. 8, no. 268 (E-283)7 December 1984
- PROCEEDINGS OF THE THIRD INTERNATIONAL IEEE VLSI MULTILEVEL INTERCONNECTION CONFERENCE 9 June 1986, SANTA CLARA, CA pages 523 - 529 DERRICK W. FOSTER ET AL. 'An in-situ Phosphorous doped polysilicon deposition process optimized for production'

## Description

This invention relates to a semiconductor device manufacturing method according to the preamble of claim 1.

Such a method is known from Journal of Applied Physics, vol. 65, no. 11, 1 June 1985, pp. 4435-4437, S.F. Gong el al., "A metal oxide silicon field effect transistor made by means of solid phase doping".

In the conventional semiconductor device, an electrode or electrode wiring formed of a polysilicon film as a main component is formed on an insulation film on the main surface area of a semiconductor substrate (wafer), and an additional insulation film is often formed on the same. In this case, impurity such as phosphorus (P) is generally doped into the polysilicon film to lower the resistance thereof so that it can be used for a desired purpose. An example in which phosphorus is doped is explained here.

In general, when a polysilicon film containing impurity is formed on the semiconductor substrate, a polysilicon film containing no impurity is first formed by deposition on the semiconductor substrate, the semiconductor substrate is heated to a temperature of higher than 600°C to thermally diffuse phosphorus while the surface of the polysilicon film is being oxidized, and then the oxide film on the surface of the polysilicon film is removed by use of chemical such as hydrofluoric acid.

However, the above method has defects that variation in the concentration of phosphorus contained in the polysilicon film is large in the surface area of the substrate (in the surface area of the wafer) and it is difficult to increase the diameter of the semiconductor substrate and since the oxide film formed on the polysilicon film is removed by use of chemical after phosphorus is diffused, the chemical may damage the underground layer through the grain boundary of the polysilicon film when the polysilicon film is formed to be thinner with increasing miniaturization of the element.

Further, in addition to the above method, there is a method of forming a polysilicon film containing no impurity on the semiconductor substrate and then doping phosphorus into the polysilicon film by use of ion-implantation.

Further, in addition to the above method, an in-situ doping method of doping impurity at the same time as formation of the polysilicon film is proposed.

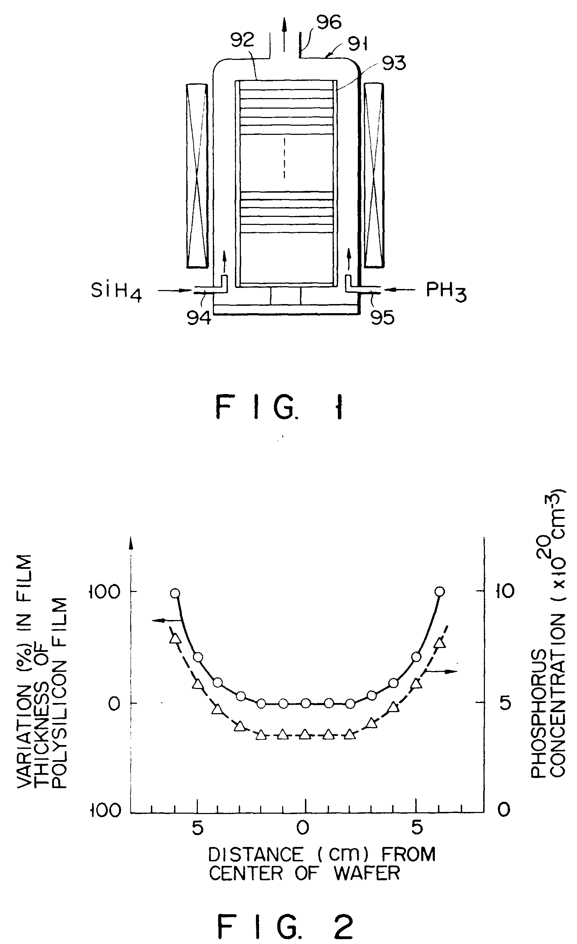

Fig. 1 schematically shows a general construction of a low pressure CVD (chemical vapor deposition) device used when effecting the in-situ doping method. In Fig. 1, 91 denotes a low pressure CVD furnace, 92, 92, --- denote semiconductor substrates (wafers) disposed in the CVD furnace, 93 denotes a sample table (boat) for holding a group of semiconductor substrates in a horizontal position, 94 denotes a gas inlet port for permitting silane (SiH₄) gas to be supplied into the CVD furnace via the lower portion thereof, 95 denotes a gas inlet port for permitting phosphine (PH₃) gas to be supplied into the CVD furnace via the lower portion thereof, and 96 denotes an exhaust port provided on the upper portion of the CVD furnace.

In the conventional in-situ doping method, SiH₄ gas and PH₃ gas are simultaneously introduced into the CVD furnace so as to form a polysilicon film by deposition and at the same time dope phosphorus.

However, in the conventional in-situ doping method, uniformity of phosphorus concentration of the polysilicon film in the surface area of the substrate can be improved to some extent, it is necessary to use a special sample table on which the semiconductor substrates are mounted and pay special attention to the flow of gas, and in a case where an ordinary sample table is used, variation in the film thickness of the polysilicon film in the substrate surface area and variation in the phosphorus concentration in the polysilicon film will become large. Further, even when a special sample table is used, the deposition speed and phosphorus concentration may become non-uniform depending on the depositing position (distance from the gas inlet port) inside the CVD furnace.

Fig. 2 shows an example of variation in the film thickness of the polysilicon film in the substrate surface area and variation in the phosphorus concentration of the polysilicon film in the substrate surface area.

Fig. 3 shows an example of a condition wherein the deposition speed of the polysilicon film and the concentration of phosphorus in the polysilicon film become non-uniform depending on the position (distance from the gas inlet port) of the semiconductor substrate inside the low pressure CVD furnace, that is, the trend of variation in the properties of semiconductor substrates.

This phenomenon is considered to occur because the attachment probability of semiconductor atoms (Si in this embodiment) when phosphorus is adsorbed on the surface is small so as to lower the deposition speed and the concentration distribution of phosphorus becomes non-uniform since the speed of decomposition of PH₃ gas for supplying impurity and the speed of decomposition of SiH₄ for depositing silicon are different to make the concentration distribution of phosphorus non-uniform. The deposition speed of the polysilicon film and the phosphorus concentration in the polysilicon film become non-uniform depending on the position of the semiconductor substrate inside the low pressure CVD furnace.

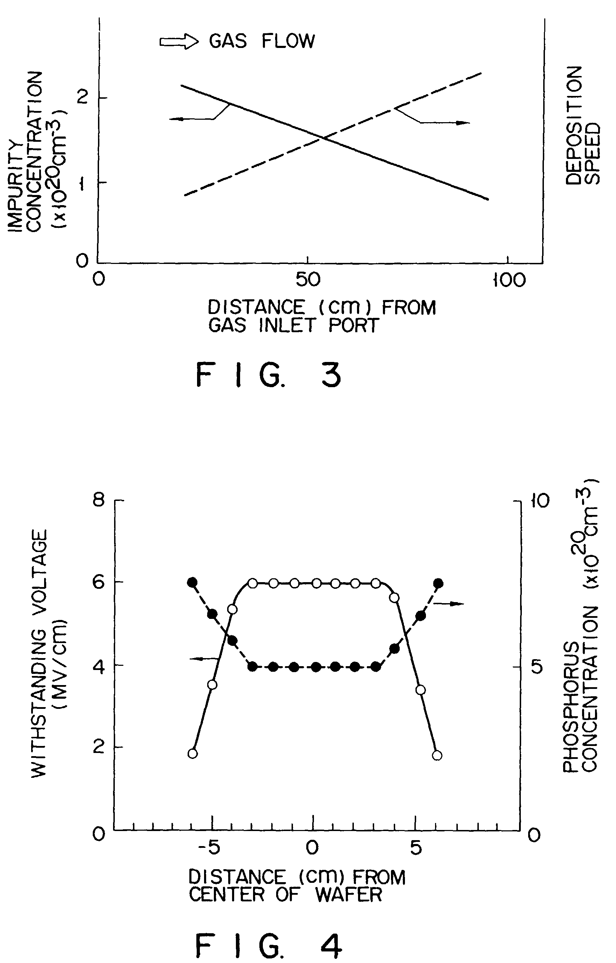

Further, as described before, it is known that when the method of thermally diffusing phosphorus while oxidizing the surface of the polysilicon film is used, the withstanding voltage of a thermal oxide film to be formed on the polysilicon film largely depends on the phosphorus concentration. Since this is particularly important in elements having a laminated structure such as EPROMs (ultra violet erasable and programmable read only memories) or DRAMs (dynamic type random access memories) using memory cells of stack structure, it is necessary to suppress variation in the phosphorus concentration of the polysilicon film in the substrate surface area. Further, since the sheet resistance of the polysilicon in the substrate surface area and the process margin at the time of etching are also largely dependent on the phosphorus concentration, variation in the phosphorus concentration of the polysilicon film in the substrate surface area must be small. Fig. 4 shows an example of variation in the withstanding voltage of the thermal oxide film in the substrate surface area and variation in the phosphorus concentration of the polysilicon film in the substrate surface area.

As described above, a method of manufacturing the conventional semiconductor device has problems that when a polysilicon film containing impurity is formed on a semiconductor substrate in which the entire portion or part of the main surface area is covered with an insulation film, variation in the impurity concentration of the polysilicon film in the substrate surface area becomes large so that the profile of the impurity concentration of the polysilicon film formed in a contact hole which is formed in part of an insulation film formed on the substrate or a trench which is formed in part of the substrate may become non-uniform in the depth direction thereof and variation in the withstanding voltage of an insulation film to be formed on the polysilicon film becomes large.

Further, a method of manufacturing the semiconductor device including the conventional in-situ doping method has a problem that the deposition speed of a polysilicon film and the phosphorus concentration in the polysilicon film become non-uniform depending on the position of the semiconductor substrate inside the low pressure CVD furnace.

An object of this invention is to provide a semiconductor device manufacturing method by which the impurity concentration of a polysilicon film containing impurity can be made uniform in the substrate surface area without using a special furnace structure or control of gas flow when the polysilicon film is formed on the semiconductor substrate whose main surface is at least partly covered with an insulation film in a low pressure CVD device.

Another object of this invention is to provide a semiconductor device manufacturing method by which the deposition speed of a polysilicon film containing impurity or the impurity concentration of a polysilicon film can be prevented from being made non-uniform depending on the position of a semiconductor substrate inside a low pressure CVD furnace when the polysilicon film is formed on the semiconductor substrate whose main surface is at least partly covered with an insulation film in a low pressure CVD device.

According to this invention, there is provided a semiconductor device manufacturing method of the initially defined type having the characterizing features of claim 1.

Preferred embodiments are listed in the dependent claims.

This invention can be more fully understood from the following detailed description when taken in conjunction with the accompanying drawings, in which:
Fig. 1 is a view schematically showing a general construction of a low pressure CVD device used for effecting the in-situ doping process;
Fig. 2 is a characteristic diagram showing an example of variation in the film thickness of a polysilicon film formed by use of the conventional in-situ doping method in the substrate surface area and variation in the phosphorus concentration of a polysilicon film in the substrate surface area;
Fig. 3 is a characteristic diagram showing an example of a trend that the deposition speed of a polysilicon film formed by use of the conventional in-situ doping method and the phosphorus concentration of the polysilicon film become non-uniform depending on the position of the semiconductor substrate in the low pressure CVD furnace;
Fig. 4 is a characteristic diagram showing an example of variation in the withstanding voltage of a thermal oxide film lying in the substrate surface area and disposed on a polysilicon film which is formed by use of the conventional thermally diffusing method and variation in the phosphorus concentration of the polysilicon film in the substrate surface area;

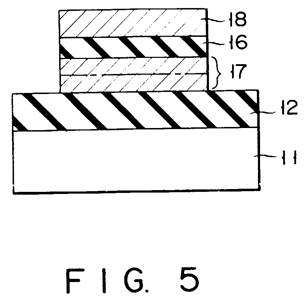

Fig. 5 is a cross sectional view showing an example of the structure of a capacitor formed by use of a first embodiment of a semiconductor device manufacturing method according to this invention;

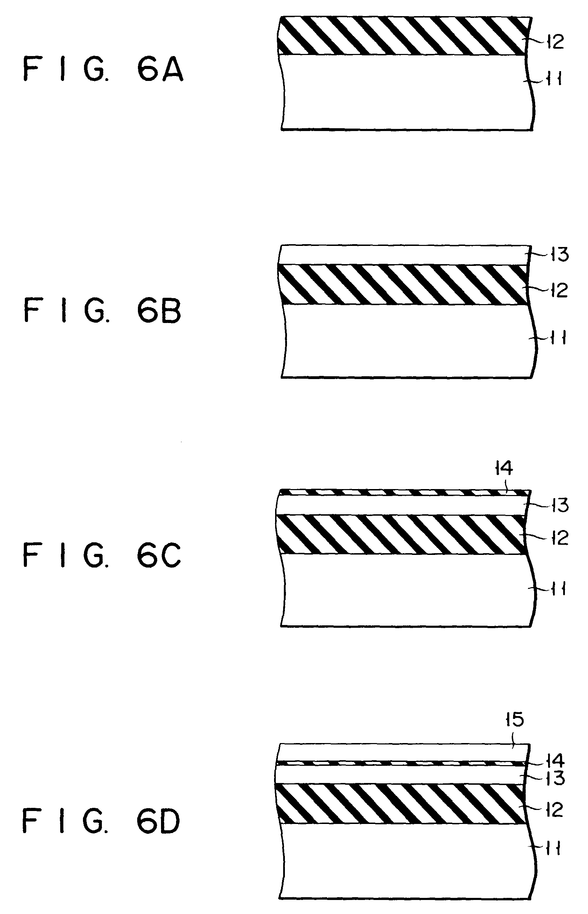

Figs. 6A to 6G are cross sectional views showing element structures in respective steps of the manufacturing method of the first embodiment;

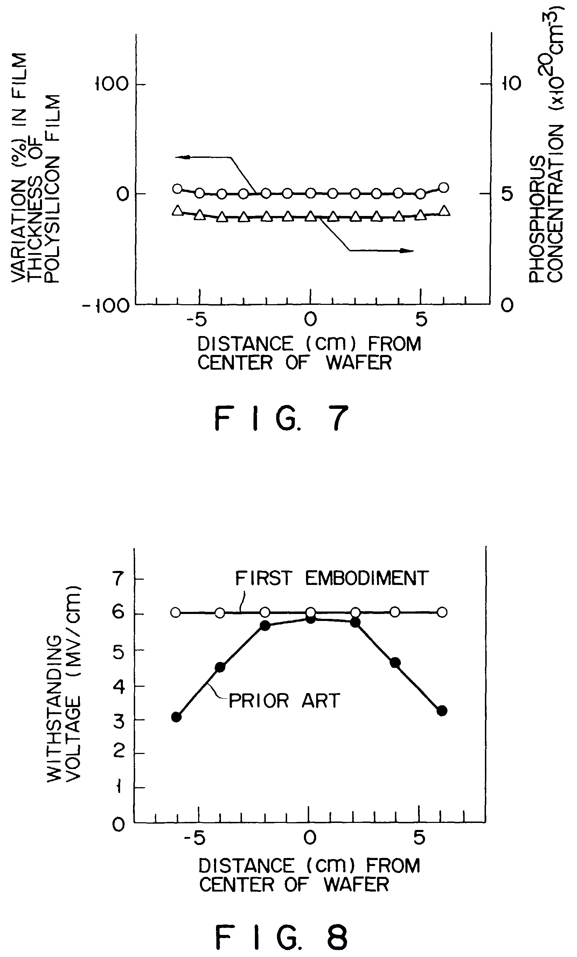

Fig. 7 is a characteristic diagram showing an example of the result of measurement of variation in the film thickness of a first polysilicon film of the capacitor shown in Fig. 5 in the substrate surface area and variation in the phosphorus concentration of the first polysilicon film in the substrate surface area;
Fig. 8 is a characteristic diagram showing an example of the result of measurement and comparison of a holding voltage of a capacitor shown in Fig. 5 and that of a capacitor formed by the conventional method;

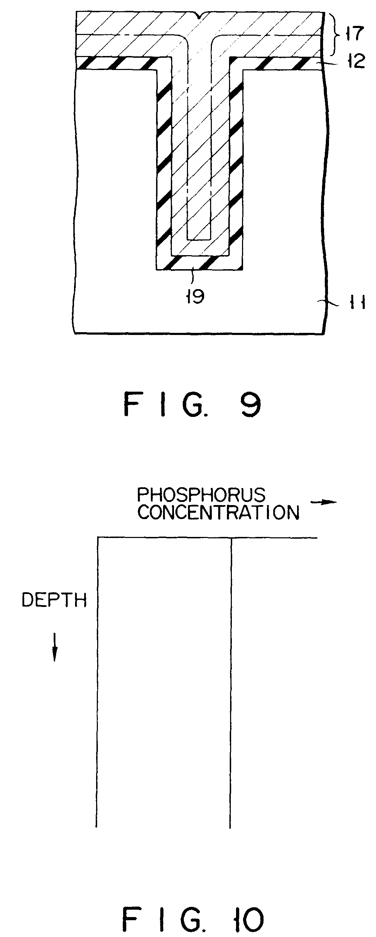

Fig. 9 is a cross sectional view showing an example of the structure of a second embodiment of a semiconductor device according to this invention;
Fig. 10 is a diagram showing an impurity profile of a polysilicon film of the device showing in Fig. 9;

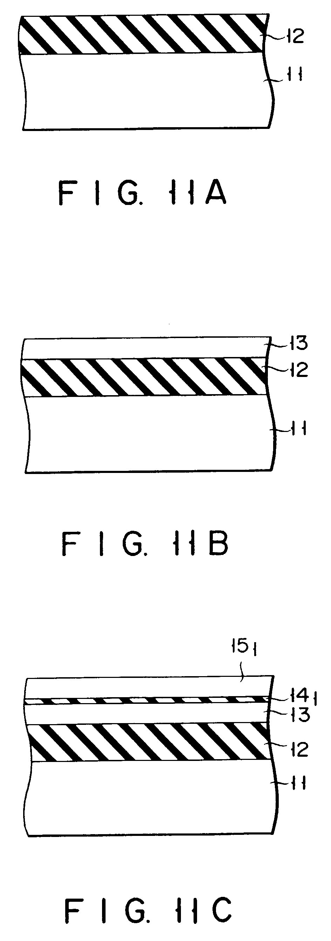

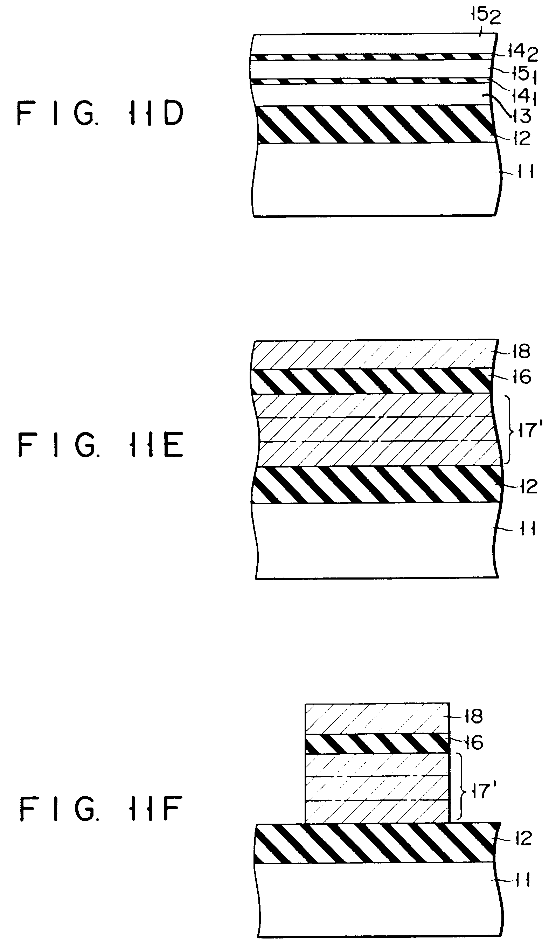

Figs. 11A to 11F are cross sectional views showing element structures in respective steps of the manufacturing method of a third embodiment of this invention;

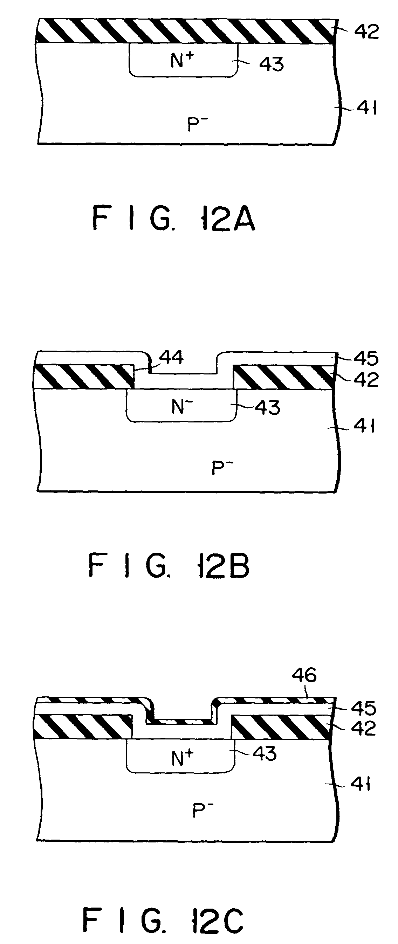

Figs. 12A to 12F are cross sectional views showing element structures in respective steps of the manufacturing method of a fourth embodiment of this invention;

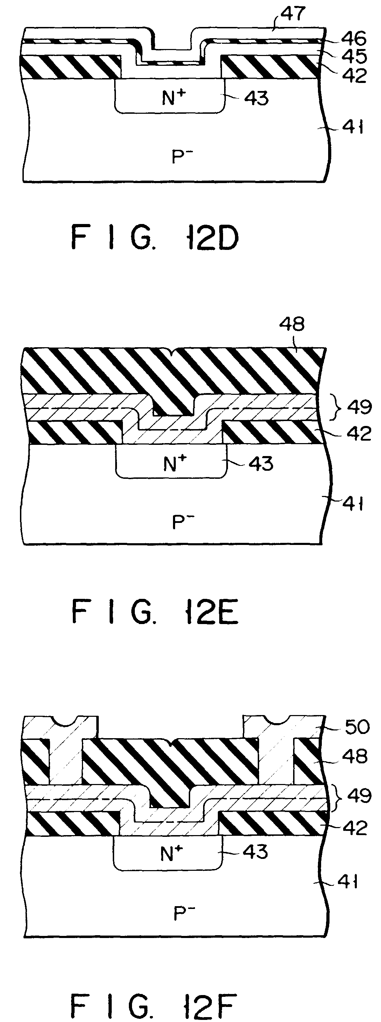

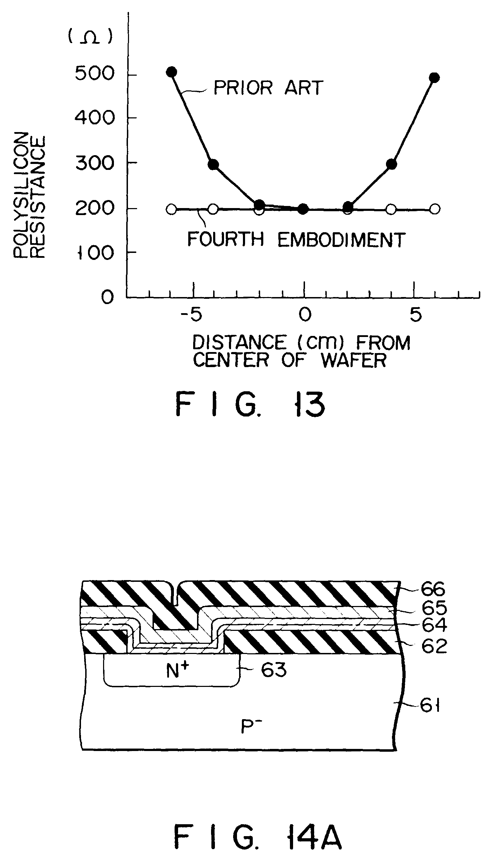

Fig. 13 is a characteristic diagram showing an example of the result of measurement of the electrical resistance of a polysilicon laminated film shown in Fig. 12;
Figs. 14A to 14D are cross sectional views showing element structures in respective steps of the manufacturing method of a fifth embodiment of this invention;

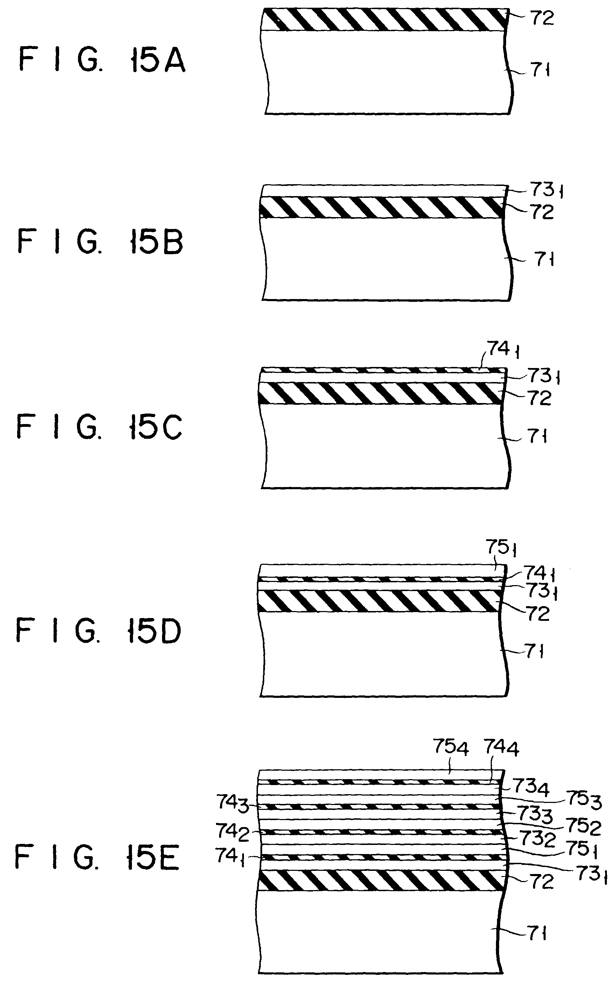

Figs. 15A to 15E are cross sectional views showing element structures in respective steps of the manufacturing method of a sixth embodiment of this invention;

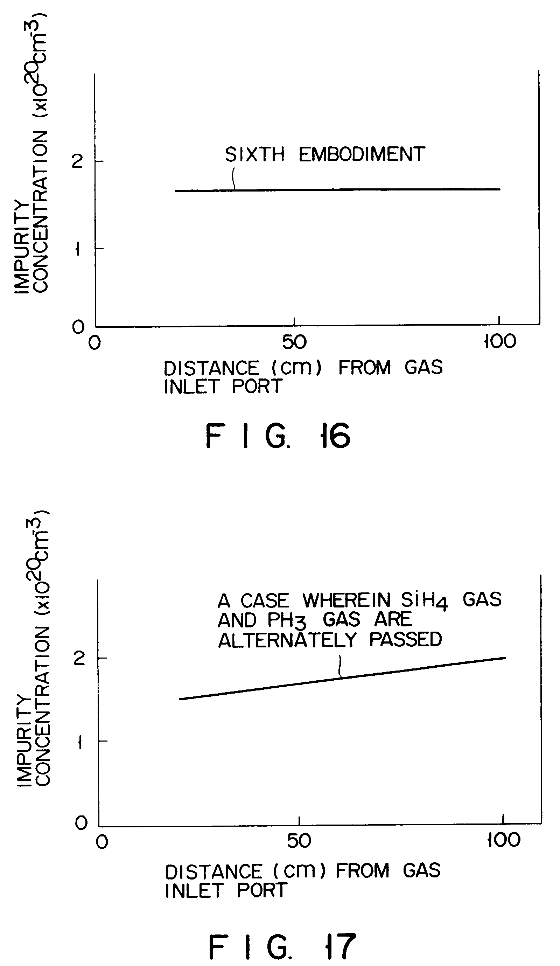

Fig. 16 is a characteristic diagram showing an example of the result of measurement of the phosphorus concentration of the polysilicon film formed by use of the method according to the sixth embodiment; and
Fig. 17 is a diagram showing an example of a condition in which the phosphorus concentration of a polysilicon film formed when SiH₄ gas and PH₃ gas are alternately passed in the fifth embodiment distributes depending on the position of the semiconductor substrate in a low pressure CVD furnace.

There will now be described an embodiment of this invention with reference to the accompanying drawings.

Fig. 5 shows an example of the structure of a capacitor formed on the main surface of a semiconductor substrate. In the drawing, 11 denotes a silicon substrate, 12 denotes a first insulation film, 17 denotes a first polysilicon film used as one of the electrodes of the capacitor, 16 denotes a second insulation film serving as a dielectric layer of the capacitor and 18 denotes a second polysilicon serving as the other electrode of the capacitor.

In the above capacitor, for example, phosphorus is contained as impurity in the first polysilicon film 17 serving as one of the electrodes. The impurity concentration in the depth direction of the first polysilicon film 17 is made uniform.

Next, an example of a method of manufacturing the capacitor of the above construction is explained.

First, as shown in Fig. 6A, the first insulation film (thermal oxide film) 12 with a film thickness of 50 nm (500Å) is formed on the entire portion of the main surface of the silicon substrate 11. Next, as shown in Fig. 6B, the silicon substrate is disposed in a horizontal position in a low pressure CVD device as shown in Fig. 1, the reaction temperature is set at 610°C and air is exhausted from the upper portion by means of a vacuum pump. The pressure at this time can be set in a range of 0.13 Pa to 1.33.10⁴ Pa (0.001 Torr to 100 Torr) and in this embodiment, the pressure is set at 66.6 Pa (0.5 Torr), and a polysilicon film 13 containing no impurity is formed to a thickness of at least 10 nm (100Å) on the first insulation film 12 by introducing SiH₄ gas from the lower portion and thermally decomposing the same on and over the first insulation film 12. In this case, it is necessary to cover the surface of the first insulation film 12 with the polysilicon film 13 of uniform surface density and it is desirable to set the thickness of the polysilicon film 13 to at least approx. 10 nm (100Å).

Next, PH₃ gas is passed under the reaction pressure of 66.6 Pa (0.5 Torr) and thermally decomposed on and over the polysilicon film 13 to adsorb and diffuse phosphorus on and near the surface of the polysilicon film so as to form a mono-layer 14 of phosphorus as shown in Fig. 6C after the above step, that is, without exposing the ( substrate to the outside air.

Then, SiH₄ gas is thermally decomposed on and over the polysilicon film 13 at the reaction temperature of 610°C to deposit a polysilicon film 15 as shown in Fig. 6D after the above step, that is, without exposing the substrate to the outside air.

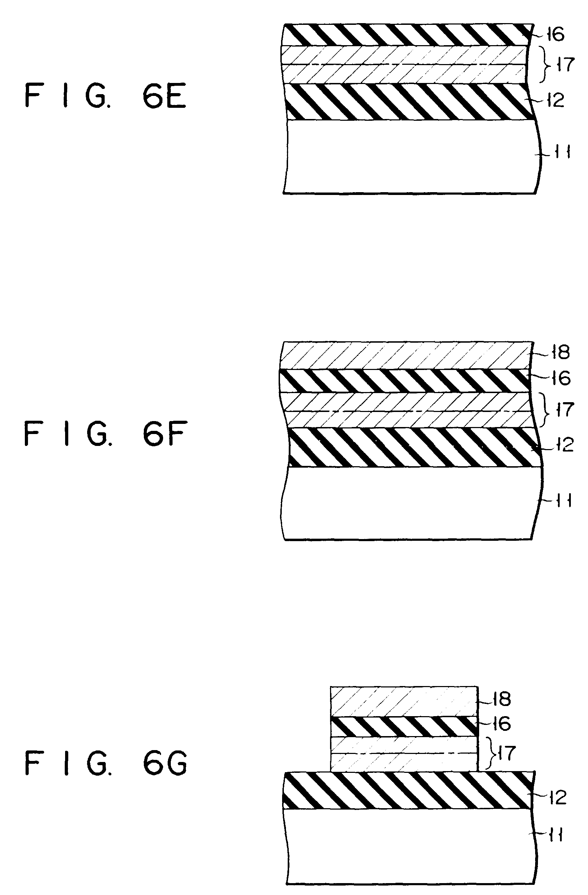

Next, as shown in Fig. 6E, the polysilicon film 15 is thermally oxidized at a temperature of approx. 1000°C to form the second insulation film (thermal oxide film) 16 with a thickness of approx. 30 nm (300Å) on the surface thereof. The second insulation film 16 serves as the dielectric layer of the capacitor. Further, phosphorus of the mono-layer 14 is diffused into the polysilicon films 13 and 15 by the heat treatment in this step so that the polysilicon films 13 and 15 may be integrated and the resistance thereof will be lowered to form the first polysilicon film 17. The first polysilicon film 17 serves as one of the electrodes of the capacitor. In this case, the thickness of the first polysilicon film 17 is 20 nm (200Å) and the average concentration of phosphorus in the first polysilicon film 17 is 5 × 10²⁰ cm⁻³.

Next, as shown in Fig. 6F, the second polysilicon film 18 having a thickness of approx. 350 nm (3500Å) and surface resistance of approx. 20Ω and serving as the other electrode of the capacitor is formed on the second insulation film 16.

Next, the second polysilicon film 18, second insulation film 16 and first polysilicon film 17 are selectively etched by the photoetching process to form the capacitor as shown in Fig. 6G.

Fig. 7 shows an example of the result of measurement of variation in the film thickness of the first polysilicon film of the capacitor formed in the above-described manner in the substrate surface area and variation in the phosphorus concentration of the first polysilicon film 17 in the substrate surface area. It is understood from Fig. 7 that the above variations are significantly improved in comparison with those for a polysilicon film formed by the in-situ doping method in which SiH₄ gas and PH₃ gas are simultaneously introduced.

Fig. 8 shows an example of the result of measurement and comparison of a holding voltage of a capacitor formed in the above-described manner and that of a capacitor formed by the conventional method. In this case, the ordinate indicates the withstanding voltage of the second insulation film 16 by the intensity of electric field when a voltage is applied between the first polysilicon film 17 and the second polysilicon film 18 and the abscissa indicates the position in the substrate surface area.

It is clearly understood from Fig. 8 that the withstanding voltage of the capacitor formed by use of the method of the above embodiment is improved in comparison with the withstanding voltage of the capacitor formed by the conventional method.

Fig. 9 is a sectional view showing a semiconductor device according to a second embodiment of the invention. Many of the components of this device are identical to those of the device shown in Fig. 5, and will therefore be designated at the same numerals as those used in Fig. 5 and will not be described in detail.

In the second embodiment (Fig. 9), a trench 19 is formed in a silicon substrate 11. The trench 19 has a rectangular cross section, and its both sides extend vertically. A first insulation film 12 is formed in this trench 19. A polysilicon film 17 is formed on the insulation film 12 and, hence, in the trench 19, and also on the surface of the silicon substrate 11. The polysilicon film 17 also contains an impurity such as phosphorus.

The polysilicon film 17, which is formed partly in the trench 19 and partly on the substrate 11 as is shown in Fig. 9, is formed in the same method as in the first embodiment (Fig. 5). As shown in Fig. 10, the film 17 has an impurity concentration (i.e., phosphorus concentration) which is uniform in the depth direction.

In the first embodiment, the first step of forming the first polysilicon film 13 containing no impurity on the semiconductor substrate in which at least part of the main surface is covered with the insulation film is effected, then the second step of forming the impurity layer on the surface of the polysilicon film 13 by passing gas containing desired impurity on and over the semiconductor substrate is effected, and the first step is repeatedly effected. However, if required, it is possible to form the polysilicon film 17 to a desired thickness by repeatedly effecting the first and second steps by a desired number of times. Figs. 11A to 11F show respective steps of a method including the above steps and according to a third embodiment of this invention. That is, as shown in Fig. 11A, a first insulation film 12 with a thickness of 50 nm (500Å) is formed on the entire portion of the main surface of a silicon substrate 11 in the same manner as in a case shown in Fig. 6A.

Next, as shown in Fig. 11B, the silicon substrate is placed in a horizontal position in a low pressure CVD device and a polysilicon film 13 containing no impurity is deposited on the first insulation film 12 in the same manner as in a case shown in Fig. 6B.

Next, as shown in Fig. 11C, PH₃ gas is passed under the reaction pressure of 66.6 Pa (0.5 Torr) and thermally decomposed on and over the polysilicon film 13 to adsorb and diffuse phosphorus on and near the surface portion of the polysilicon film so as to form a first mono-layer 14₁ of phosphorus after the above step, that is, without exposing the substrate to the outside air. Then, SiH4 gas is thermally decomposed on and over the polysilicon film 13 at the reaction temperature of 610°C to deposit a polysilicon film 15₁ without exposing the substrate to the outside air.

After this, as shown in Fig. 11D, a second mono-layer 14₂ is formed on the polysilicon film 15₁ in the same manner as described above and then a polysilicon film 15₂ is deposited on the mono-layer.

Next, as shown in Fig. 11E, the polysilicon film 15₂ is thermally oxidized at a temperature of approx. 1000°C to form a second insulation film (thermal oxide film) 16 with a thickness of approx. 30 nm (300Å) on the surface thereof. The second insulation film 16 serves as the dielectric layer of the capacitor. Further, phosphorus of the first and second mono-layers 14₁ and 14₂ is diffused into the polysilicon films 13, 15₁ and 15₂ by the heat treatment in this step so that the polysilicon films 13, 15₁ and 15₂ may be integrated and the resistance thereof will be lowered to form a first polysilicon film 17'. The first polysilicon film 17' serves as one of the electrodes of the capacitor. Next, a second polysilicon film 18 having a thickness of approx. 350 nm (3500Å) and surface resistance of approx. 20Ω and serving as the other electrode of the capacitor is formed on the first polysilicon film 17'.

Next, the second polysilicon film 18, second insulation film 16 and first polysilicon film 17' are sequentially and selectively etched by the photoetching process to form the capacitor as shown in Fig. 11F.

In the method of the above embodiment, the thicknesses of the polysilicon films 13, 15₁ and 15₂ are determined so as to set the average concentration of impurity in the original polysilicon films 13, 15₁ and 15₂ constituting the first polysilicon film 17' to a desired value.

In the methods of the first and third embodiments, the polysilicon film 17 or 17' is formed on the silicon substrate in which the entire portion of the main surface is covered with the first insulation film 12. Next, an example of a method of forming a polysilicon film on a semiconductor substrate having an impurity region formed in the substrate surface area under an opening which is formed in the first insulation film is explained as a fourth embodiment with reference to Figs. 12A to 12F.

First, as shown in Fig. 12A, a first insulation film (thermal oxide film) 42 is formed to a thickness of 50 nm (500Å) on the entire portion of the main surface of a P⁻-type silicon substrate 41. Then, As ions are ion-implanted into the silicon substrate 41 through the first insulation film 42 and heat treatment is effected to diffuse the As ions so as to form an N⁺-type region 43 in part of the silicon substrate 41.

Next, as shown in Fig. 12B, a contact hole 44 is formed in the first insulation film 42 on the N⁺-type region 43 and then SiH₄ gas is thermally decomposed on and over the insulation film 42 at the reaction temperature of 610°C and under the reaction pressure of 66.6 Pa (0.5 Torr) in the low pressure CVD device to deposit a polysilicon film 45 containing no impurity on the first insulation film 42 and in the contact hole 44.

After this, as shown in Fig. 12C, PH₃ gas is thermally decomposed on and over the polysilicon film 45 under the reaction pressure of 66.6 Pa (0.5 Torr) in the low pressure CVD device to form a mono-layer 46 of phosphorus on the surface of the polysilicon film.

Then, SiH₄ gas is thermally decomposed on and over the insulation film 45 at the reaction temperature of 610°C in the low pressure CVD device to deposit a polysilicon film 47 as shown in Fig. 12D.

Next, as shown in Fig. 12E, a passivation film (for example, a phosphorus-silicate-glass film : PSG film) 48 is formed on the entire surface of the substrate. Further, phosphorus contained in the mono-layer 46 of phosphorus is diffused into the polysilicon films 45 and 47 in the heat treatment process in which the passivation film 48 is formed and a later melting step is effected, thereby integrating the polysilicon films 45 and 47 and lowering the resistance thereof to form a polysilicon film 49. The polysilicon film 49 serves as an electrode lead-out wiring extending from the N⁺-type region 43.

Next, as shown in Fig. 12F, the passivation film 48 is selectively etched to form a contact hole, and then an aluminum-silicon film is formed on the entire surface of the substrate and patterned to form an electrode 50.

Fig. 13 shows an example of the result of measurement of electrical resistance of the polysilicon film 49 of the element formed in the above-described manner. As is clearly understood from Fig. 12, variation in the electrical resistance in the substrate surface area is smaller in the case of the polysilicon film 49 formed by the method of the fourth embodiment than in the case of the polysilicon film formed by the conventional method and a proper electrical characteristic can be attained. This is considered to be because phosphorus is uniformly doped in the polysilicon film 49.

A method according to a fifth embodiment of this invention is explained. The method of this embodiment is to form a polysilicon film containing impurity on a semiconductor substrate in which part of the main surface is covered with an insulation film and the other portion is exposed to a conductive layer.

First, a semiconductor structure shown in Fig. 14A is formed. In Fig. 14A, 61 denotes a P⁻-type silicon substrate, 62 a first insulation film, 63 an N⁺-type region, 64 a polysilicon film containing impurity, 65 a conductive film formed of, for example, MoSi, and 66 a second insulation film. The polysilicon film 64 is formed by the same method as that for forming the polysilicon film 49 in the fourth embodiment.

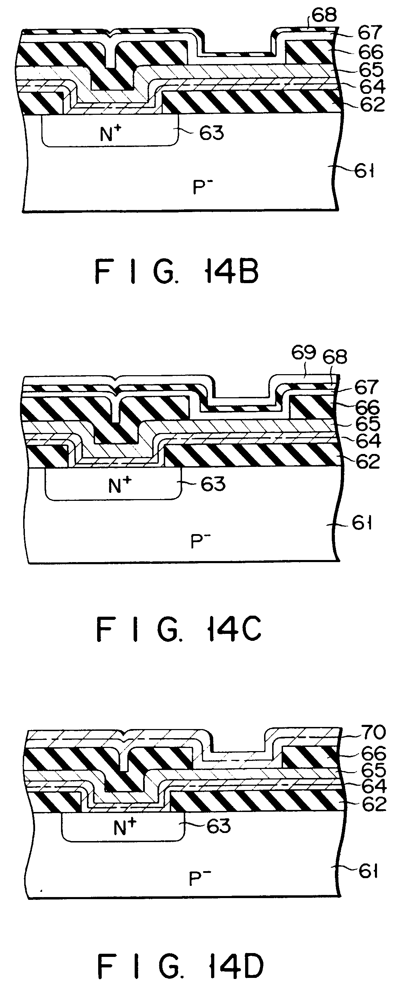

Next, as shown in Fig. 14B, part of a second insulation film 66 is etched to form a via-hole and then SiH₄ gas is thermally decomposed on and over the second insulation film 66 at the reaction temperature of 610°C and under the reaction pressure of 66.6 Pa (0.5 Torr) in the low pressure CVD device to deposit a polysilicon film 67 containing no impurity on the second insulation film 66. After this, PH₃ gas is thermally decomposed on and over the polysilicon film 67 under the reaction pressure of 66.6 Pa (0.5 Torr) in the low pressure CVD device to form a mono-layer 68 of phosphorus on the surface of the polysilicon film.

Then, SiH₄ gas is thermally decomposed on and over the polysilicon film 68 at the reaction temperature of 610°C in the low pressure CVD device to deposit a polysilicon film 69 as shown in Fig. 14C.

After this, the semiconductor structure is subjected to the annealing process at a high temperature to diffuse phosphorus of the mono-layer 68 into the polysilicon films 67 and 69, thereby integrating the polysilicon films 67 and 69 and lowering the resistance thereof to form a polysilicon film 70. The polysilicon film 70 serves as a lead-out wiring of the conductive film 65 formed of MoSi.

The conductive film 65 may be formed of at least one of semiconductor, metal, metal silicate and metal nitride instead of MoSi.

Next, a method according to a sixth embodiment of this invention is explained.

That is, as shown in Fig. 15A, a first insulation film (thermal oxide film) 72 is formed to a thickness of 50 nm (500Å) on the entire portion of the main surface of a silicon substrate 71.

Next, as shown in Fig. 15B, the silicon substrate is placed in a horizontal position in the low pressure CVD device and polysilicon film 73₁ is formed on first insulation film 72 and then, as shown in Fig. 15C. PH₃ gas of 10 sccm is passed under a condition that the reaction temperature is set at 610°C and the reaction pressure is set at 133.3 Pa (1 Torr) and is thermally decomposed on and over the polysilicon film 73₁ so as to form a mono-layer 74₁ of phosphorus on the surface of the polysilicon film 73₁. After PH₃ gas is passed for 10 minutes, supply of PH₃ gas is interrupted.

Then, SiH₄ gas of 10 sccm is passed under a condition of the reaction temperature of 610°C and the reaction pressure of 66.6 Pa (0.5 Torr) so as to form a polysilicon film 75₁ to a thickness of 50 nm (500Å) on the mono-layer 74₁ as shown in Fig. 14D after the above step, that is, without exposing the substrate to the outside air.

After this, the three steps shown in Figs. 15B, 15C and 15D are repeatedly effected by three times to form a polysilicon film 73₂, a mono-layer 74₂ of phosphorus, a polysilicon film 75₂, a polysilicon film 73₃, a mono-layer 74₃ of phosphorus, a polysilicon film 75_{3,} a polysilicon film 73₄, a mono-layer 74₄ of phosphorus, and a polysilicon film 75₄ as shown in Fig. 15E. In this case, the film thicknesses of the polysilicon films are so determined as to set the total thickness of the polysilicon films 73₁ to 73₄ and 75₁ to 75₄ to approx. 300 nm (3000Å) if the thickness of each of the mono-layers 74₁ to 74₄ is neglected.

Fig. 16 shows an example of the result of measurement of the phosphorus concentration in the polysilicon films after annealing the thus formed polysilicon films 73₁ to 73₄ and 75₁ to 75₄ at a high temperature. It is understood from Fig. 16 that the distribution of the phosphorus concentration of the polysilicon films is substantially uniform irrespective of the position of the semiconductor substrate in the low pressure CVD furnace. The reason for this can be explained as follows. That is, the phosphorus concentration of a polysilicon film formed when SiH₄ gas and PH₃ gas are alternately passed is distributed as shown in Fig. 17 according to the position of the semiconductor substrate in the low pressure CVD furnace and the phosphorus concentration tends to be higher as the distance from the gas inlet port is longer. The reason for this is not clear but may be considered to be because phosphorus adsorbed on the surface of the film after PH₃ gas supply is interrupted is removed when SiH₄ is passed again and PH₃ gas may be transferred to the downstream side of the gas flow.

In the method of the sixth embodiment, when a polysilicon film containing impurity is formed on a semiconductor substrate, a step of forming a polysilicon film containing no impurity, a step of depositing a polysilicon film and at the same time doping desired impurity and a step of forming an impurity layer near the surface of the polysilicon film by passing gas containing desired impurity on and over the semiconductor substrate are combined in a desired order and the thus combined three steps are repeatedly effected to form the polysilicon film to a desired thickness.

Therefore, it becomes possible to improve the uniformity of the phosphorus concentration and the uniformity of the film thickness by obtaining a proper film thickness by combining a method of depositing a polysilicon film by separately introducing SiH₄ gas and PH₃ gas and the in-situ doping method of depositing a polysilicon film by simultaneously introducing SiH₄ gas and PH₃ gas as in the conventional method.

The deposition speed in the in-situ doping process of depositing a polysilicon film containing impurity by simultaneously introducing SiH₄ gas and PH₃ gas can be set less one half of the deposition speed in the process of depositing a polysilicon film by passing SiH₄ gas. Therefore, the total sum of time for the process of depositing the polysilicon film by passing SiH₄ gas and time for the process of forming a mono-layer of phosphorus on the surface of the polysilicon film by passing PH₃ gas may become substantially equal to time for the in-situ doping process of depositing the polysilicon film to the same thickness, and thus in the method of the sixth embodiment, a problem that the deposition time becomes long can be prevented.

In the method of each of the above embodiments, phosphorus is doped as impurity by use of PH₃ gas, but it is possible to use another dopant (for example, at least one of B, As, Sb, Aℓ and Ga), and if B is used as the dopant, for example, B₂H₆ gas may be used and if As is used as the dopant, for example, AsH₃ gas may be used.

In the method of each of the above embodiments, SiH₄ gas is used to deposit the polysilicon film, but, for example, Si₂H₆ gas may be used.

In the method of each of the above embodiments, the polysilicon film is deposited at the reaction temperature of 610°C, but it is also possible to dope impurity in the same manner as in each of the above embodiments in a case where the reaction temperature is set below 600°C and a silicon film other than a polysilicon film, for example, an amorphous silicon film is deposited.

Further, in the method of each of the above embodiments, the deposition of the polysilicon film and impurity doping are effected under the pressure of 66.6 Pa to 133 Pa (0.5 Torr to 1 Torr), but it is also possible to effect the same under the lowered pressure of 0.13 Pa to 1.33.10⁴ Pa (0.001 Torr to 100 Torr).

As described above, when using the semiconductor device manufacturing method of the invention, it is possible to manufacture a semiconductor device in which variation in impurity concentration of the polysilicon film formed on the semiconductor substrate in which at least part of the main surface is covered with the insulation film can be improved.

Further, when using the semiconductor device manufacturing method of this invention, it is possible to manufacture a semiconductor device in which, when a polysilicon film containing impurity is formed on the semiconductor substrate in which at least part of the main surface is covered with the insulation film in the low pressure CVD device, the impurity concentration of the polysilicon film can be made uniform in the substrate surface area without using a special furnace structure and controlling the gas flow.

Further, when using the semiconductor device manufacturing method of this invention, it is possible to manufacture a semiconductor device in which, when a polysilicon film containing impurity is formed on the semiconductor substrate in which at least part of the main surface is covered with the insulation film in the low pressure CVD device, the deposition speed of the polysilicon film and the impurity concentration of the polysilicon film can be prevented from becoming non-uniform depending on the position of the semiconductor substrate in the low pressure CVD furnace.

## Claims

1. A semiconductor device manufacturing method comprising:
- a first step of covering at least part of the main surface area of a semiconductor substrate (11; 41; 71) with a first insulation film (12; 42; 72);
- a second step of forming a first non-single crystal silicon film (13; 45; 73₁) on the entire surface;
**characterized** by
- a third step of passing a gas containing a desired impurity on said semiconductor substrate to form an impurity monolayer (14; 46; 74₁) on the surface of said first non-single crystal silicon film;
- a fourth step of forming a second non-single crystal silicon film (15; 47; 75₁) containing no impurity after said third step, said second non-single crystal silicon film (15; 47; 75₁) being formed on said impurity monolayer;
- a fifth step of diffusing impurity from said impurity monolayer into said first and second non-single crystal silicon films after said fourth step thereby forming a polysilicon layer with a uniform impurity concentration
- an LPCVD apparatus being used for forming each of the non-single crystal silicon films (13; 45, 73₁, 15, 47, 75₁) and the impurity monolayer (14; 46; 74₁); and
- the successive formation of the first non-single crystal silicon film (13; 45; 73₁), the second non-single crystal silicon film (15, 47, 75₁) and the impurity monolayer (14; 46; 74₁) being carried out without exposing the substrate to the outside air.

2. A method according to claim 1, characterized in that said first non-single crystal silicon film (13; 45; 73₁) contains no impurity.

3. A semiconductor device manufacturing method according to claim 1 or 2, characterized in that said first non-single crystal silicon film (13; 45; 73₁) is a polysilicon film.

4. A device manufacturing method according to claim 1 or 2, characterized in that said second non-single crystal silicon film (15; 47; 75₁) is a polysilicon film.

5. A device manufacturing method according to claim 1 or 2, characterized in that said fifth step is effected at the same time as a step of forming a second insulation film (16; 48) on the surface of said second non-single crystal silicon film (15; 47; 75₁) by the thermal oxidation process.

6. A semiconductor device manufacturing method according to claim 1 or 2, characterized by further comprising a sixth step of repeatedly effecting a combination of said third and fourth steps by a plurality of times after said fourth step and before said fifth step.

7. A device manufacturing method according to claim 1, characterized in that said impurity monolayer (14; 46; 74₁) contains at least one selected from a group consisting of P, B, As, Sb, Aℓ and Ga.

8. A device manufacturing method according to claim 1 or 2, characterized in that the film thickness of said first and second non-single crystal silicon films (13; 45; 73₁) are determined such that the average impurity concentration of said first and second non-single crystal silicon (15; 47; 75₁) films after said impurity is diffused are set to desired values.

9. A semiconductor device manufacturing method according to claim 1, characterized by doping a desired impurity into said first non-single crystal silicon film (13; 45; 73₁) at the same time as forming the first non-single crystal silicon film (13; 45; 73₁).

10. A device manufacturing method according to claim 9, characterized in that the film thicknesses of said first and second non-single crystal silicon films (13; 45; 73₁; 15; 47; 75₁) are determined such that the average impurity concentration of said first and second non-single crystal silicon (13; 45; 73₁; 15; 47; 75₁) films after said impurity is diffused are set to desired values.

11. A device manufacturing method according to claim 2 or 9, characterized in that said second to fourth steps are repeatedly effected by a desired number of times to set the total thickness of said non-single crystal silicon film to a desired thickness.

12. A device manufacturing method according to claim 9, characterized in that said impurity monolayer contains at least one selected from a group consisting of P, B, As, Sb, Aℓ and Ga.

13. A method according to any of claims 1 to 5, characterized in that an opening (44) which reaches the surface of said semiconductor substrate (11; 41; 71) is formed in said first insulation film (42) and said first non-single crystal silicon film (45) is also formed in said opening (44).

14. A method according to claim 1 or 2, characterized in that said first non-single crystal silicon film (13; 45; 73₁) is an amorphous silicon film.

## Patentansprüche

1. Herstellungsverfahren für Halbleitereinrichtungen, umfassend:
- Einen ersten Schritt, in dem wenigstens ein Teil Hauptoberflächengebiets eines Halbleitersubstrats (11; 41; 71) mit einem ersten Isolationsfilm (12; 42; 72) bedeckt wird;
- einen zweiten Schritt, in dem ein erster nicht-Einzelkristall-Siliziumfilm (13; 45; 73₁) auf der gesamten Oberfläche gebildet wird;
gekennzeichnet durch
- einen dritten Schritt, in welchem ein Gas, das eine gewünschte Verunreinigung enthält, auf das Halbleitersubstrat geleitet wird, um eine Verunreinigungs-Monoschicht (14; 46; 74₁) auf der Oberfläche des ersten nicht-Einzelkristall-Siliziumfilms zu bilden;
- einen vierten Schritt, in dem ein zweiter nicht-Einzelkristall-Siliziumfilm (15; 47; 75₁), der keine Verunreinigung enthält, nach dem dritten Schritt gebildet wird, wobei der zweite nicht-Einzelkristall-Siliziumfilm (15; 47; 75₁) auf der Verunreinigungs-Monoschicht gebildet wird;
- einen fünften Schritt, in welchem eine Verunreinigung aus der Verunreinigungs-Monoschicht in die ersten und zweiten nicht-Einzelkristall-Siliziumfilme nach dem vierten Schritt diffundiert werden, wodurch eine Polysiliziumschicht mit einer gleichförmigen Verunreinigungskonzentration gebildet wird;
- wobei eine LPCVD-Vorrichtung zum Bilden jeder der nicht-Einzelkristall-Siliziumfilme (13; 45, 73₁, 15, 47, 75₁) und der Verunreinigungs-Monoschicht (14; 46; 74₁) verwendet wird; und
- die successive Bildung des ersten nicht-Einzelkristall-Siliziumfilms (13; 45; 73₁), des zweiten nicht-Einzelkristall-Siliziumfilms (15, 47, 75₁) und der Verunreinigungs-Monoschicht (14; 46; 74₁) ohne Freilegen des Substrats zu der Außenluft ausgeführt wird.

2. Verfahren nach Anspruch 1 dadurch gekennzeichnet, daß der erste nicht-Einzelkristall-Siliziumfilm (13; 45; 73₁) keine Verunreinigung enthält.

3. Herstellungsverfahren für Halbleitereinrichtungen nach Anspruch 1 oder 2, dadurch gekennzeichnet, daß der erste nicht-Einzelkristall-Siliziumfilm (13; 45; 73₁) ein Polysiliziumfilm ist.

4. Herstellungsverfahren für Halbleitereinrichtungen nach Anspruch 1 oder 2, dadurch gekennzeichnet, daß der zweite nicht-Einzelkristall-Siliziumfilm (15; 47; 75₁) ein Polysiliziumfilm ist.

5. Herstellungsverfahren für Halbleitereinrichtungen nach Anspruch 1 oder 2, dadurch gekennzeichnet, daß der fünfte Schritt gleichzeitig mit dem Schritt eines Bildens eines zweiten Isolationsfilms (16; 48) auf der Oberfläche des zweiten nicht-Einzelkristall-Siliziumfilms (15; 47; 75₁) durch den thermischen Oxidationsprozeß ausgeführt wird.

6. Herstellungsverfahren für Halbleitereinrichtungen nach Anspruch 1 oder 2, dadurch gekennzeichnet, daß es ferner einen sechsten Schritt umfaßt, bei dem eine Kombination der dritten und vierten Schritte mehrere Male nach dem vierten Schritt und vor dem fünften Schritt ausgeführt wird.

7. Herstellungsverfahren Anspruch 1, dadurch gekennzeichnet, daß die Verunreinigungs-Monoschicht (14; 46; 741) wenigstens eine Verunreinigung enthält, die aus der Gruppe gewählt ist, die aus P, B, As, Sb, Aℓ und Ga besteht.

8. Herstellungsverfahren nach Anspruch 1 oder 2, dadurch gekennzeichnet, daß die Filmdicken der ersten und zweiten nicht-Einzelkristall-Siliziumfilme (13; 45; 73₁) so bestimmt werden, daß die durchschnittliche Verunreinigungskonzentrationen der ersten und zweiten nicht-Einzelkristall-Siliziumfilme (15; 47; 75₁), nachdem die Verunreinigung diffundiert ist, auf gewünschte Werte eingestellt werden.

9. Herstellungsverfahren für Halbleitereinrichtungen nach Anspruch 1, gekennzeichnet, durch ein Dotieren einer gewünschten Verunreinigung in den ersten nicht-Einzelkristall-Siliziumfilm (13; 45; 73₁) gleichzeitig mit einer Bildung des ersten nicht-Einzelkristall-Siliziumfilms (13; 45; 73₁).

10. Herstellungsverfahren nach Anspruch 9, dadurch gekennzeichnet, daß die Filmdicken der ersten und zweiten nicht-Einzelkristall-Siliziumfilme (13; 45; 73₁; 15; 47; 75₁) so bestimmt werden, daß die durchschnittliche Verunreinigungskonzentrationen der ersten und zweiten nicht-Einzelkristall-Siliziumfilme (13; 45; 73₁; 15; 47; 75₁), nachdem die Verunreinigung diffundiert ist, auf gewünschte Werte eingestellt werden.

11. Herstellungsverfahren nach Anspruch 2 oder 9, dadurch gekennzeichnet, daß die zweiten bis vierten Schritte wiederholt für eine gewünschte Anzahl von Malen ausgeführt werden, um die Gesamtdicke des nicht-Einzelkristall-Siliziumfilms auf eine gewünschte Dicke einzustellen.

12. Herstellungsverfahren nach Anspruch 9, dadurch gekennzeichnet, daß die Verunreinigungs-Monoschicht wenigstens eine Verunreinigung enthält, die aus einer Gruppe gewählt ist, die aus P, B, As, Sb, Aℓ und Ga besteht.

13. Verfahren nach einem der Ansprüche 1 bis 5, dadurch gekennzeichnet, daß eine Öffnung (44), die die Oberfläche des Halbleitersubstrats (11; 41; 71) erreicht, in dem dritten Isolationsfilm (42) gebildet wird und der erste nicht-Einzelkristall-Siliziumfilm (45) ebenfalls in der Öffnung (44) gebildet wird.

14. Verfahren nach Anspruch 1 oder 2, dadurch gekennzeichnet, daß der erste nicht-Einzelkristall-Siliziumfilm (13; 45; 73₁) ein amorpher Siliziumfilm ist.

## Revendications

1. Procédé de fabrication d'un dispositif semiconducteur comportant :
- une première étape de recouvrement d'au moins une partie de la région superficielle principale d'un substrat semiconducteur (11; 41 ; 71 ) avec une première pellicule d'isolement (12; 42; 72);
- une seconde étape de formation d'une première pellicule de silicium polycristallin (13; 45; 73₁ ) sur la totalité de la surface;
caractérisé par
- une troisième étape de délivrance d'un gaz contenant une impureté désirée sur ledit substrat semiconducteur pour former une monocouche d'impureté (14; 46; 74₁) sur la surface de ladite première pellicule de silicium polycristallin;
- une quatrième étape de formation d'une seconde pellicule de silicium polycristallin (15; 47; 75₁) ne contenant pas d'impureté après ladite troisième étape, ladite seconde pellicule de silicium polycristallin (15; 47; 75₁) étant formée sur ladite monocouche d'impureté;
- une cinquième de diffusion d'impureté depuis ladite monocouche d'impureté dans lesdites première et seconde pellicules de silicium polycristallin après ladite quatrième étape en formant ainsi une couche de silicium polycristallin à concentration d'impureté uniforme;
- un dispositif de dépôt chimique en phase vapeur à basse pression étant utilisé pour former chacune des pellicules de silicium polycristallin (13; 45; 73₁, 15, 47, 75₁) et la monocouche d'impureté (14; 46; 74₁); et
- la formation successive de la première pellicule de silicium polycristallin (13; 45; 73₁), de la seconde pellicule de silicium polycristallin (15, 47, 75₁) et de la monocouche d'impureté (14; 46; 74₁) étant effectuées sans exposer le substrat à l'air extérieur.

2. Procédé selon la revendication 1, caractérisé en ce que ladite première pellicule de silicium polycristallin (13; 45; 73₁) ne contient pas d'impureté.

3. Procédé de fabrication d'un dispositif semiconducteur selon la revendication 1 ou 2, caractérisé en ce que ladite première pellicule de silicium polycristallin (13; 45; 73₁) est une pellicule de silicium polycristallin.

4. Procédé de fabrication d'un dispositif semiconducteur selon la revendication 1 ou 2, caractérisé en ce que ladite seconde pellicule de silicium polycristallin (15; 47; 75₁) est une pellicule de silicium polycristallin.

5. Procédé de fabrication d'un dispositif semiconducteur selon la revendication 1 ou 2, caractérisé en ce que ladite cinquième étape est effectuée en même temps qu'une étape de formation d'une seconde pellicule d'isolement (16; 48) sur la surface de ladite seconde pellicule de silicium polycristallin (15; 47; 75₁) par oxydation thermique.

6. Procédé de fabrication d'un dispositif semiconducteur selon la revendication 1 ou 2, caractérisé en ce qu'il comporte en outre une sixième étape de réalisation répétitive d'une combinaison desdites troisième et quatrième étapes une pluralité de fois après ladite quatrième étape et avant ladite cinquième étape.

7. Procédé de fabrication d'un dispositif semiconducteur selon la revendication 1, caractérisé en ce que ladite monocouche d'impureté (14; 46; 74₁) contient au moins un élément choisi parmi le groupe constitué par P, B, As, Sb, Aℓ et Ga.

8. Procédé de fabrication d'un dispositif semiconducteur selon la revendication 1 ou 2, caractérisé en ce que l'épaisseur de pellicule desdites première et seconde pellicules de silicium polycristallin (13; 45; 73₁) sont déterminées de telle sorte que la concentration en impureté moyenne desdites première et seconde pellicules de silicium polycristallin (15; 47; 75₁) après diffusion de ladite impureté sont fixées à des valeurs désirées.

9. Procédé de fabrication d'un dispositif semiconducteur selon la revendication 1, caractérisé par le dopage d'une impureté désirée dans ladite première pellicule de silicium polycristallin (13; 45; 73₁) simultanément à la formation de la première pellicule de silicium polycristallin (13; 45; 73₁).

10. Procédé de fabrication d'un dispositif semiconducteur selon la revendication 9, caractérisé en ce que les épaisseurs de pellicule desdites première et seconde pellicules de silicium polycristallin (13; 45; 73₁; 15; 47; 75₁) sont déterminées de telle sorte que la concentra-concentration en impureté moyenne desdites première et seconde pellicules de silicium polycristallin (13; 45; 73₁; 15; 47; 75₁) après diffusion de ladite impureté sont fixées à des valeurs désirées.

11. Procédé de fabrication d'un dispositif semiconducteur selon la revendication 2 ou 9, caractérisé en ce que lesdites seconde à quatrième étapes sont effectuées de façon répétitive un nombre désiré de fois pour fixer l'épaisseur totale de ladite pellicule de silicium polycristallin à une épaisseur désirée.

12. Procédé de fabrication d'un dispositif semiconducteur selon la revendication 9, caractérisé en ce que ladite monocouche d'impureté contient au moins un élément choisi parmi le groupe constitué de P, B, As, Sb, Aℓ et Ga.

13. Procédé selon l'une quelconque des revendications 1 à 5, caractérisé en ce qu'une ouverture (44) atteignant la surface dudit substrat semiconducteur (11; 41; 71) est pratiquée dans ladite première pellicule d'isolement (42) et ladite première pellicule de silicium polycristallin (45) est également formée dans ladite ouverture (44).

14. Procédé selon la revendication 1 ou 2, caractérisé en ce que ladite première pellicule de silicium polycristallin (13; 45; 73₁) est une pellicule de silicium amorphe.
